# EUROPEAN PATENT APPLICATION

(11) **EP 1 897 639 A1**
(43) Date of publication of application: **12.03.2008**
(21) Application number: 06745746.5
(22) Date of filing: 27.04.2006
(51) Int. Cl.: B22F 9/00, B22F 1/00, B22F 9/24, C22C 13/00

(54) **TIN POWDER-CONTAINING COLLOIDAL LIQUID AND METHOD FOR PRODUCING SAME**

(30) Priority: 27.04.2005 JP 2005129626
(71) Applicant: MITSUI MINING & SMELTING CO., LTD., Tokyo 141-8584 (JP)
(72) Inventor: SAKAUE, Takahiko, c/o Hikoshima Smelting Co., Ltd., Shimonoseki-shi, Yamaguchi 750-0093 (JP); YOSHIMARU, Katsuhiko, /o Hikoshima Smelting Co., Ltd., Shimonoseki-shi, Yamaguchi 750-0093 (JP)
(74) Representative: Bohmann, Armin K.
(86) International application number: PCT/JP2006/308818
(87) International publication number: WO 2006/118183

(57) **Abstract**

It is an object of the present invention to provide a tin powder-containing colloidal solution which can provide an ultra fine tin powder with certain dispersibility and not contaminated with metals such as chromium, and to provide its manufacturing method. To achieve the object, a tin powder-containing colloidal solution which contains a tin powder which does not contain the metals, which is **characterized in that** the tin powder has an average particle diameter (D_{IA}) of not more than 2-micron meter, is employed. Further, a method for manufacturing a tin powder-containing colloidal solution is employed, which is **characterized in that** a soluble tin compound is added to a polar non-aqueous solution to prepare a tin ion containing solution and then a sodium borohydride solution is gradually added thereto with agitating the tin ion containing solution.

## Description

### Technical Field

The present invention relates to a tin powder-containing colloidal solution and manufacturing method of the same. Particularly, the present invention relates to a tin powder-containing colloidal solution which contains an ultra-fine tin powder with certain dispersibility and not contaminated with metals such as chromium, and manufacturing method of the tin powder-containing colloidal solution.

### Background Art

Solder powders are now widely used as a constituting powder of conductive adhesives for filling via holes of multilayer printed wiring boards and for positioning of IC devices and the like when these are mounted on printed wiring boards.

The solder powders are now generally composed of so-called lead-free solder materials. Solders conventionally used are eutectic solder of 63 wt % tin and 37 wt % lead. However, there arises a caution on the amount of environmental loads, water pollution or the like caused by wasting of the lead containing components of consumer use electronic products represented by cathode-ray tubes of TV sets and other electronics devices. Then the use of lead-free solders has been main stream as shown above from the view point of reducing the total lead amount contained in consumer use electronic products.

Solder powders are constituted of micro-particles of the metal powders and for the manufacturing methods, the mechanical pulverization method, atomization method, vapor-phase reduction method and gas vaporization method are applied. But for manufacturing of the solder powders or tin powders constituting solder powders, applying the atomization method is popular as disclosed in Patent Document 1 (Japanese Patent Laid-Open No. 2000-15482). The atomization method involves manufacturing by atomizing a liquid containing a metal such as tin, making the atomized liquid into individual droplets and then cooling the droplets. The advantage of solder powders and tin powders obtained by the manufacturing method is that the powders are excellent in dispersibility against the powders obtained by the wet process.

However, tin powders manufactured by the atomization method generally have very broad particle size distributions, and the particle size distribution is limited to be in the range from 1-micron meter to 10-micron meter when the powder particles are intended to be fine. So, it is difficult to obtain the tin powders having an average particle diameter of not more than 5-micron meter without coarse particles when observed directly in the electron microscope. Tin powders having such a broad particle size distribution and an average particle diameter exceeding 5-micron meter have the following problems.

First problem is that a conductive paste using a tin powder having a broad particle size distribution and an average particle diameter exceeding 5-micron meter has drawbacks of the poor formability of fine circuits and the poor plugging ability of the micro via holes.

Second problem is that the use of a coarse tin powder obtained by the atomization method for filling via holes of multilayer printed wiring boards exhibits a poor filling ability of the via holes. In addition, since the large particle diameter exhibits a poor sintering ability at low temperatures, and the connection reliability with outer layer circuits located outside the via holes may sometimes lost.

As shown above, a micro particle of tin powder excellent in plugging ability of micro via holes of micro wiring circuits and can secure the low-temperature fusing ability, which can be used for similar applications as tin powders obtained by the conventional atomization method has been required.

Patent Document 2 discloses a method in which cores of nano-level size in an independently dispersed state are first prepared and the reduced metal is deposited onto the cores when metal micro-particles is deposited by adding a reducing agent to a metal compound solution. In the example disclosed, the core particles of 100-nano meter to 200-nano meter are obtained for silver and palladium.

Although tin is exemplified as one of metals in Patent Document 2, the influence of a reducing agent is too big for obtaining micro-particles of tin. So the method in which hydrazins exemplified by hydrazine and metal salts exemplified by ferrous sulfate are used has a difficulty in obtaining tin powders of 100-nano meter level with excellent particle dispersibility, and no examples are shown.

On the other hand, Patent Document 3 discloses a method using a divalent chromium ion solution as a reducing agent. In the presence of a protective agent to suppress aggregation of tin particles, the divalent chromium ion solution is add to a tin compound solution for the deposition by reduction of tin metal, tin particles having an average particle diameter of not more than 100-nano meter are obtained.

[Patent Document 1] Japanese Patent Laid-Open No. 2000-15482
[Patent Document 2] Japanese Patent Laid-Open No. 10-317022
[Patent Document 3] Japanese Patent Laid-Open No. 2003-306707

However, although the manufacturing method disclosed in Patent Document 3 can manufacture tin powders of nano-size, it is afraid that the obtained tin powder may be contaminated with chromium. The regulations of the use of environmental pollutants such as chromium for electronics devices and electronic devices have recently been strengthened. So a situation now is that conductive pastes using a tin power containing chromium cannot be replaced to solders.

Therefore, according to the requirements in the markets, it is an object of the present invention to provide a tin powder-containing colloidal solution containing an ultra fine tin powder with good dispersibility and without contamination of different metals such as chromium which use is avoided, and to provide manufacturing method of the tin powder-containing colloidal solution.

### Disclosure of the Invention

Then, as a result of studies, the present inventors has acquired an idea that an ultra fine tin powder without contamination of different metals such as chromium and has a certain dispersibility can be obtained by using a specific reducing agent for tin ions in a non-aqueous solution.

Tin powder-containing colloidal solution: the present invention provides a tin powder-containing colloidal solution comprising a tin powder composed of tin and inevitable impurities, characterized in that the tin powder has an average particle diameter (D_{IA}) of not more than 2.0-micron meter.

In the tin powder-containing colloidal solution according to the present invention, the tin powder preferably has an average particle diameter (D_{IA}) of 0.01-micron meter to 1.0-micron meter.

In the tin powder-containing colloidal solution according to the present invention, the tin powder preferably has an aggregation degree which is represented by average volume-cumulative particle diameter (D₅₀)/average particle diameter (D_{IA}) of not more than 5, and a maximum particle diameter (Dₘₐₓ) of not more than 5.0-micron meter.

A method for manufacturing a tin powder-containing colloidal solution: the present invention provides a manufacturing method for a tin powder-containing colloidal solution characterized in that a soluble tin compound is added to a polar non-aqueous solution to prepare a tin ion containing solution, and then a sodium borohydride solution is gradually added to the tin ion containing solution with agitating the tin ion containing solution.

In the manufacturing method according to the present invention shown above, the time for adding the sodium borohydride solution is preferably 10 min. to 120 min.

In the manufacturing method according to the present invention shown above, preferred non-aqueous solution is methanol or ethanol, and preferably has a water content of not more than 30 wt %.

In the manufacturing method according to the present invention shown above, preferred concentration of the soluble tin compound is from 0.001-mol/l to 0.5-mol/l.

In the manufacturing method according to the present invention shown above, 0.5-mol to 5.0-mol of sodiumborohydride is preferably added against to 1.0 mol of the soluble tin compound.

In the manufacturing method according to the present invention shown above, preferable concentration of the sodium borohydride is not more than 1.0-mol/l.

In the manufacturing method according to the present invention shown above, a dispersant may be added for improving the dispersibilityof the reductively depositedtin particles, and is preferably selected from one or mixture of ketones, amines, polyols and ethers.

In the manufacturing method according to the present invention shown above, not more than 3.0-mol of the dispersant is preferably added against to 1.0 mol of the soluble tin compound.

In the tin powder-containing colloidal solution according to the present invention, the micro particles of tin powder is hard to be oxidized in the atmosphere, and can be stored for a long term. The tin powder contained therein is not contaminated with different metals such as chromium, and it is a fine micro powder having an average particle diameter of not more than 2.0-micron meter and further not more than 1.0-micron meter with a good dispersibility. The manufacturing method according to the present invention is excellent in the industrial productivity, and allows the efficient and stable mass production of the tin powder-containing colloidal solution.

### Best Mode for Carrying Out the Invention

Hereinafter, the best mode for carrying out the present invention will be described.

### (The tin powder-containing colloidal solution according to the present invention)

The tin powder-containing colloidal solution according to the present invention contains a tin powder having an average particle diameter (D_{IA}) of not more than 2.0-micron meter, preferably 0.01 to 1.0-micron meter. Average particle diameter exceeding 2.0-micron meter of the tin powder results a problem of the poor formability of fine circuits and the poor plugging ability of micro via holes and other problems as in the case of tin powders obtained by the above-mentioned atomization method. The average particle diameter (D_{IA}) is determined from observation images of tin powder particles by FE-SEM (field emission scanning electron microscope) or SEM (scanning electron microscope). The diameters of plurality (for example, 20 particles to 100 particles) of the tin micropowder particles in the tin powder are measured from the images directly, and averaging the diameters through conversion by the imaging magnification.

The above tin powder is not contaminated with metals such as chromium resulting from the manufacturing method. "is not contaminated with metals " here means that each impurity content in the tin powder is approximately not more than 5.0 ppm. Without toxic metals as such allows avoiding troubles such as deterioration of environment by using.

The aggregation degree of the tin powder which is represented by (average volume-cumulative particle diameter: D₅₀)/(average particle diameter: D_{IA}) is preferably not more than 5. With the aggregation degree exceeding 5, the particle dispersibility may be poor and the tin powder cannot be made into a paste. Even if a paste can be obtained, the paste has a problem of very poor filling ability and the like. The average volume-cumulative particle diameter (D₅₀) is a value measured using a laser diffraction scattering type particle size distribution measuring instrument.

The aggregation degree defined by (D₅₀)/(D_{IA}) is a parameter employed according to the following reason. That is, the value of D₅₀ is not obtained by observing directly the diameters of particles actually one by one. This is because particles constituting many kinds of metal powders are not a monodisperse powder. Many particles are not completely separated individually, but are in the state in which a plurality of particles aggregate. The laser diffraction scattering type particle size distribution measuring method can be said to determine the volume-cumulative particle diameter with aggregated particles treated as one particle (aggregated particles and/or a primary particle).

On the other hand, the average particle diameter (D_{IA}) is obtained by image processing on observed images of a metal powder observed by using a scanning electron microscope. The average particle diameter (D_{IA}) is a particle diameter measured directly from FE-SEM or SEM observation images and converted by the magnification. So, it can clearly find primary particles, but does not reflect the presence of the aggregated state of the particles at all.

Under such considerations, the present inventors have decided to specify an aggregation degree as a value calculated as D_{50/}D_{IA} by using D₅₀ and D_{IA}. That is, in tin powders under the same manufacturing condition, assuming that the values of D₅₀ and D_{IA} can be measured with the same precision, the value of D₅₀ reflecting the presence of the aggregated state to the measurement is believed to be lager than the value of D_{IA} from the above-mentioned logic.

At this time, without the aggregated state of a metal powder, the value of D₅₀ approaches boundlessly to the value D_{IA} and the value of D₅₀/D_{IA} as the aggregation degree approaches to 1. The powder can be said to be a monodisperse powder having no aggregated state of particles at all when the aggregation degree reaches 1.

The tin powder according to the present invention desirably has a maximum particle diameter (Dₘₐₓ) of not more than 5.0-micron meter. With the maximum particle diameter (Dₘₐₓ) exceeding 5.0-micron meter, when the tin powder is made into a conductive paste, the conductive paste is poor in formability of fine circuits. And also poor in the plugging ability of micro via holes when it is filled into via holes, it is likely to lose the connection reliability with outer layer circuits located outside the via holes because the fusing temperature becomes high and the size change due to the large shrinking. The maximum particle diameter (Dₘₐₓ) is measured using a laser diffraction scattering type particle size distribution measuring instrument.

### (The manufacturing method of the tin powder-containing colloidal solution according to the present invention)

Then, the manufacturing method of the tin powder-containing colloidal solution according to the present invention will be described.
In the manufacturing method according to the present invention, a tin ion-containing solution is prepared by adding a soluble tin compound to a polar non-aqueous solution. A soluble tin compound is not especially limited, and stannous chloride (SnCl₂/2H₂O) and tin sulfate (SnSO₄) may be included, but stannous chloride is preferably used because of easy handling or else.

As a polar non-aqueous solution used here, alcohols and glycols may be included, but methanol and ethanol are preferably used. Ethanol is most suitable in view of reactivity. Propanol and the like of alcohols have a drawback in poor solubility of tin compounds and sodium borohydride.

The polar non-aqueous solution preferably has a water content of not more than 30 wt %, further preferably not more than 10 wt %. With the water content exceeding 30 wt %, un-reacted tin compounds remain and side reactions such as tin oxide formation may easily progress.

The concentration of soluble tin compound is preferably from 0.001-mol/l to 0.5-mol/l, further preferably from 0.005-mol/l to 0.1-mol/l. With the concentration exceeding 0.5-mol/l, the aggregation easily occurs. With the concentration of less than 0.001-mol/l, both the efficiency and the reactivity might be poor and results low yield.

A dispersant for improving the dispersibility of tin particles may be further added in the non-aqueous solution. As a dispersant, one or mixture selected from ketones, amines, polyols and ethers is used. Acetylacetone and cyclohexanone as ketones, ethanol amine as amines, glycerin as polyols, and diethylene glycol mono-butyl ether acetate as ethers are preferably used. The adding amount of such a dispersant is preferably not more than 3.0-mol of the dispersant to 1.0-mol of the soluble tin compound. Even with the adding amount of the dispersant exceeding 3.0-mol, an effect on a further improvement in dispersibility of tin particles cannot be obtained. The other hand, the particle dispersibility sometimes deteriorates and such addition is also economically disadvantageous.

Then, a sodium borohydride solution is gradually added to the tin ion containing solution obtained as described above while the tin ion containing solution is agitated. The sodium borohydride solution mentioned herein is a solution in which sodium borohydride is dissolved in an alcohol or a mixture solvent of an alcohol and water. As the alcohol, methanol, ethanol and the like can be used. Using just ethanol as a solvent is most preferred. However, such an alcohol may be used as a mixture with water. Use of water prevents increase of cost for a solvent to allow supply of more cheep and higher-quality products. In the case where water and an alcohol are used in mixture, in the solution after the completion of the addition, the mixing rate of the alcohol/water is preferably 2.5 or more by weight, more preferably 4.0 or more. This is because less water amount is preferable by nature. That is, if the water amount is increased such that the weight ratio mentioned herein has a value of less than 2.5, it results the product cost low, but a high-quality tin powder cannot be obtained. Also it may result broad particle size distribution and poor shelf life in a tin powder-containing colloidal solution as a finished product. On the other hand, reducing the water amount as much as possible is naturally preferable, but taking into account the most possible cost reduction with the product quality maintained, approximately 20 may be the upper limit of alcohol/water ratio. By applying a sodium borohydride solution which use a solvent described above as a reducing agent for tin ions can prevent contamination of different metals such as chromium, and provides a fine tin powder having good dispersibility.

The time for adding the sodium borohydride solution is preferably from 10 min to 120 min. With the time for adding of less than 10 min, powder particles of a produced tin powder mutually aggregate as is the case where the sodium borohydride solution is added all at once. Also with time for adding of exceeding 120 min, effects on prevention of aggregation of the powder particles and enhancement of the particle dispersibility do not improve and the time for adding provides an economical drawback.

0.5-mol to 3.0-mol of the sodium borohydride is preferably added against to 1.0-mol of the soluble tin compound. With the addition amount of sodium borohydride of less than 0.5-mol, a large amount of the un-reacted tin compound remains and depositing powder particles easily aggregate. In contrast, with the addition amount of sodium borohydride exceeding 3.0-mol, it results the deposition of the tin powder too fast, and results the mutual aggregation of the depositing powder particles severe. So, both are not preferable.

In the above manufacturing method according to the present invention, the concentration of sodium borohydride as a reducing agent is preferably not more than 1.0-mol/l, more preferably in the range from 0.01-mol/l to 0.5-mol/l. With the concentration of sodium borohydride exceeding 1.0-mol/l, the concentration of the reducing agent is too high with respect to the concentration of tin; resulting the rate of the deposition by reduction excessive and the mutual aggregation of depositing powder particles severe. In contrast, with the concentration of sodium borohydride less than 0.01-mol/l, the rate of the deposition by reduction of tin ions is slow and do not satisfy the industrial productivity.

Industrially, each of a tin ion containing solution ("A solution") and a sodium borohydride solution ("B solution") are prepared and then the "B solution" is preferably added to the "A solution" in batch system or continuous system to manufacture a tin powder-containing colloidal solution.

The tin powder-containing colloidal solution according to the present invention thus obtained is kept as it is followed by removing of the supernatant liquid. Then, the precipitate is subjected to rinsing several times with re-pulping by a solvent such as ethanol, followed by subjecting the precipitate to centrifugation if required. A tin powder is thus separated and obtained. The filtration and rinsing may be conducted by using a ceramic filter, polymer membrane filter and the like if required. The tin powder thus obtained is made, for example, into a conductive paste to constitute material of a solder.

Hereinafter, the present invention will be specifically described through Examples and Comparative Examples.

### [Example 1]

As shown in Table 1, 800 g (1,000 ml) of ethanol and 16 g (0.07-mol) of stannous chloride di-hydrate were mixed in a 2 L beaker to prepare a tin compound solution having a concentration of 0.07-mol/l as "A solution". 5 g (0.13-mol) of sodium borohydride (SBH) was dissolved in 500 ml of ethanol as "B solution".

The "B solution" was added to the "A solution" in 20 min at 30-degree C while the "A solution" was agitated; the solution was further agitated for 20 min; thereafter, the tin powder rinsed by re-pulping was charged into a mixture solvent of 90 wt % terpineol and 10 wt % pure water to prepare a tin powder-containing colloidal solution. The average particle diameter (D_{IA}), average volume-cumulative particle diameter (D₅₀), maximum particle diameter (Dₘₐₓ) and impurity content of the obtained tin powder were investigated. The results are shown in Table 2.

The average particle diameter D_{IA} (micron meter) was measured by the above-mentioned method. The average volume-cumulative particle diameter (D₅₀) and the maximum particle diameter (Dₘₐₓ) were measured by using a laser diffraction scattering type particle size distribution measuring instrument Micro Trac HRA 9320-X100 (Leeds&Northrup Co.) after mixing 0.1 g of a tin powder with a 0.1% aqueous solution of SN Dispersant 5468 (SAN NOPCO Ltd.), followed by dispersing the mixture for 5 min by an ultrasonic homogenizer (NISSEI Corp., US-300T).

The impurity content (ppm) was determined from analysis on the resultant solution obtained by dissolving whole tin powder in a hydrochloric acidic solution by using ion coupled plasma (ICP) emission spectrometer.

### [Example 2]

As shown in Table 1, a tin powder-containing colloidal solution was prepared as in Example 1, except a mixed solution of 400 ml of ethanol and 100 ml of water is used instead of 500 ml of ethanol used for preparing the SBH solution in Example 1. The average particle diameter (D_{IA}), average volume-cumulative particle diameter (D₅₀), maximum particle diameter (Dₘₐₓ) and impurity content of the obtained tin powder were investigated as in Example 1. The results are shown in Table 2.

### [Example 3]

As shown in Table 1, a tin powder-containing colloidal solution was prepared as in Example 1, except 10 g (0.01-mol) of acetylacetone as a dispersant was further added to "A solution". The average particle diameter (D_{IA}), average volume-cumulative particle diameter (D₅₀), maximum particle diameter (Dₘₐₓ) and impurity content of the obtained tin powder were investigated as in Example 1. The results are shown in Table 2.

### [Comparative Examples]

### (Comparative Example 1)

As shown in Table 1, a tin powder-containing colloidal solution was prepared as in Example 1, except 500 ml of water instead of 500 ml of ethanol was used for preparing the SBH solution in Example 1. The average particle diameter (D_{IA}), average volume-cumulative particle diameter (D₅₀), maximum particle diameter (Dₘₐₓ) and impurity content of the obtained tin powder were investigated as in Example 1. The results are shown in Table 2.

### (Comparative Example 2)

As shown in Table 1, a tin powder-containing colloidal solution was prepared as in Example 3, except "B solution" was added to "A solution" all at once. The average particle diameter (D_{IA}), average volume-cumulative particle diameter (D₅₀), maximum particle diameter (Dₘₐₓ) and impurity content of the obtained tin powder were investigated as in Example 1. The results are shown in Table 2.

### (Comparative Example 3)

Tin particles were prepared by a method described in Japanese Patent Laid-Open No. 2003-306707.
10 g of stannous chloride di-hydrate and 30 g of polyvinyl pyrrolidone were dissolved in 2 L of pure water; and the pH of the solution was adjusted to not more than 1.0 by using hydrochloric acid to obtain a mother solution.

30 g of chromium tri-chloride hexa-hydrate was dissolved in 1 L of pure water to prepare an aqueous chromium solution. The aqueous chromium solution was made to pass through zinc powder and added to the mother solution to compose tin particles. The average particle diameter (D_{IA}), average volume-cumulative particle diameter (D₅₀), maximum particle diameter (Dₘₐₓ) and impurity content of the obtained tin powder were investigated as in Example 1. The results are shown in Table 2.

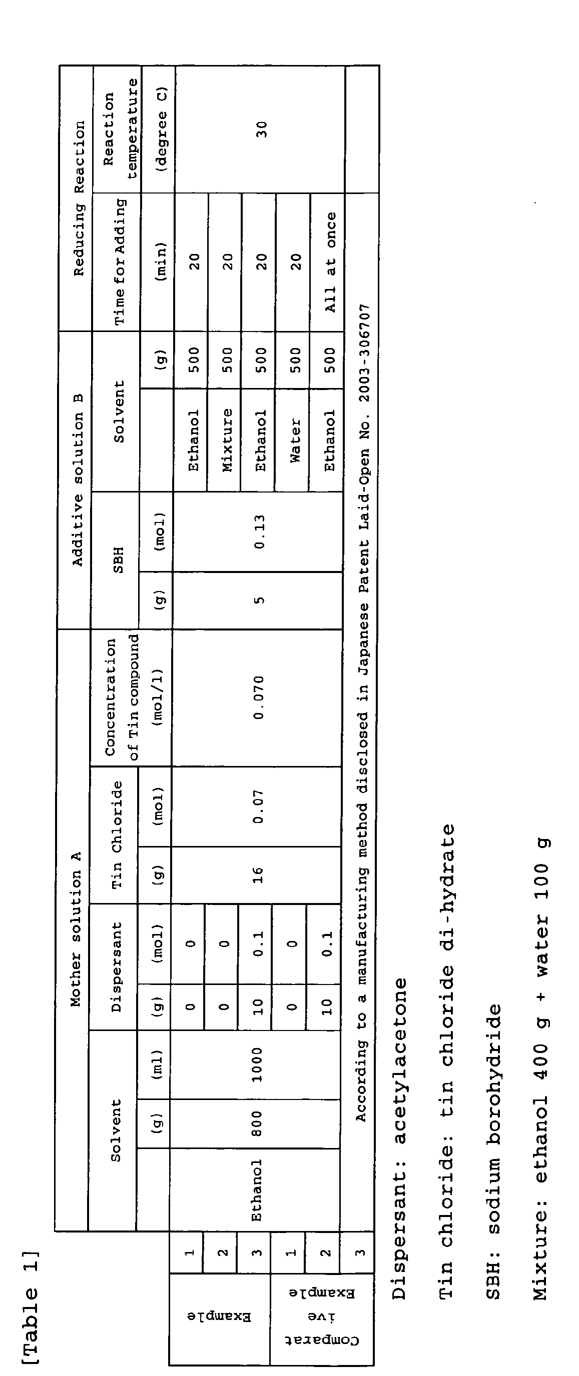

**[Table 2]**

| | Particle size distribution (micron meter) | | | D₅₀/D_{IA} | Impurity metal content (ppm) | Note |
|---|---|---|---|---|---|---|
| | D_{IA} | D₅₀ | Dₘₐₓ | | | |
| Example 1 | 0.15 | 0.37 | 1.37 | 2.47 | Impurity components such as Cr and Zn as impurity components of each are not more than 5 ppm | |
| Example 2 | 0.13 | 0.45 | 2.52 | 3.46 | | |
| Example 3 | 0.10 | 0.35 | 1.26 | 3.50 | | |
| Comparative Example 1 | 0.13 | 0.48 | 7.13 | 3.69 | | white precipitate is found in solution |
| Comparative Example 2 | Not measurable due to severe particle aggregation | | | | | Severe particle aggregation is found |
| Comparative Example 3 | 0.08 | 0.23 | 13.10 | 3.29 | Cr: 292 ppm, Zn: 13 ppm | |

As is clear from the results in Table 2, the tin powders obtained in Examples 1 to 3 have an average particle diameter (D_{IA}) of around 0.1-micron meter, a maximum particle diameter (Dₘₐₓ) of not more than 3-micron meter and an aggregation degree of not more than 3.5, which are in the good range.

In contrast, in Comparative Example 1, a large number of white precipitates are generated in the reducing reaction and a maximum particle diameter (Dₘₐₓ) is around 7-micron meter. In Comparative Example 2, the obtained tin powder show severe aggregation to be a lump. In Comparative Example 3, in which chromium tri-chloridehexahydratewas used as a reducing agent, the obtained tin powder was contaminated with chromium to be avoided as an environmental pollutant.

### Industrial Applicability

The tin powder-containing colloidal solution according to the present invention provides an ultra fine tin powder which contains no metals such as chromium and has certain dispersibility. Accordingly, a conductive paste using the tinpowder is suitably used as analternativematerial to solder materials and the like. Since the tin powder obtained by being separated from the tin powder-containing colloidal solution according to the present invention is micro-particles and excellent in the particle dispersibility, it is suitable for applications of a conductive adhesive used for filling via holes of multilayer printed wiring boards and positioning IC components and the like when these are mounted on printed wiring boards. The manufacturing method according to the present invention does not employ a complicated and special method, and does not require any additional capital investment. Accordingly, the method is excellent in the industrial productivity with applying the existing facility, and allows the efficient and stable mass production of the tin powder-containing colloidal solution according to the present invention.

## Claims

1. A tin powder-containing colloidal solution comprising a tin powder composed of tin and an inevitable impurity, **characterized in that** the tin powder has an average particle diameter (D_{IA}) of not more than 2.0-micron meter.

2. The tin powder-containing colloidal solution according to claim 1, wherein the tin powder has an average particle diameter (D_{IA}) of 0.01-micron meter to 1.0-micron meter.

3. The tin powder-containing colloidal solution according to claim 1 or 2, wherein the tin powder has an aggregation degree which is represented by (average volume-cumulative particle diameter: D₅₀)/(average particle diameter: D_{IA}) of not more than 5, and a maximum particle diameter (Dₘₐₓ) of not more than 5.0-micron meter.

4. A method for manufacturing a tin powder-containing colloidal solution, **characterized in that** a soluble tin compound is added to a polar non-aqueous solution to prepare a tin ion containing solution and then a sodium borohydride solution is gradually added thereto with agitating the tin ion containing solution.

5. The method for manufacturing a tin powder-containing colloidal solution according to claim 4, wherein a time for adding the sodium borohydride solution is 10 min. to 120 min.

6. The method for manufacturing a tin powder-containing colloidal solution according to claim 4 or 5, wherein the non-aqueous solution is methanol or ethanol and has a water content of not more than 30 wt %.

7. The method for manufacturing a tin powder-containing colloidal solution according to anyone of claims 4 to 6, wherein a concentration of the soluble tin compound is from 0.001-mol/l to 0.5-mol/l.

8. The method for manufacturing a tin powder-containing colloidal solution according to anyone of claims 4 to 7 , wherein 0. 5-mol to 5.0-mol of the sodium borohydride is added against to 1.0 mol of the soluble tin compound.

9. The method for manufacturing a tin powder-containing colloidal solution according to anyone of claims 4 to 8, wherein a concentration of the sodium borohydride is not more than 1.0-mol/l.

10. The method for manufacturing a tin powder-containing colloidal solution according to anyone of claims 4 to 9, wherein a dispersant is added to the non-aqueous solution.

11. The method for manufacturing a tin powder-containing colloidal solution according to claim 10, wherein the dispersant is one or mixture selected from ketones, amines, polyols and ethers.

12. The method for manufacturing a tin powder-containing colloidal solution according to claim 10 or 11, wherein not more than 3.0 mol of the dispersant is added against to 1.0 mol of the soluble tin compound.
